# EUROPEAN PATENT APPLICATION

(11) **EP 4 714 895 A1**
(43) Date of publication of application: **25.03.2026**
(21) Application number: 24858023.5
(22) Date of filing: 28.06.2024
(51) Int. Cl.: B66F 9/20, B66F 9/12, B65G 1/04, B66F 9/075, B65G 1/137, B65G 49/07

(54) **SEMICONDUCTOR STACKER, MECHANICAL ARM THEREOF, AND OPERATION METHOD THEREFOR**

(30) Priority: 25.08.2023 CN 202311086859; 25.08.2023 CN 202311087425
(71) Applicant: Meetfuture Technology (Shanghai) Co., Ltd., Shanghai 201306 (CN)
(72) Inventor: LIU, Yinglong, Shanghai 201306 (CN); MIAO, Feng, Shanghai 201306 (CN)
(74) Representative: Balder IP Law, S.L.
(86) International application number: PCT/CN2024/102551
(87) International publication number: WO 2025/044479

(57) **Abstract**

The present disclosure provides a semiconductor stacker, a robotic arm of the semiconductor stacker, and a method for operating the robotic arm, which relate to the technical field of semiconductor stereoscopic warehouse. The robotic arm includes a robotic arm bottom plate, a driving arm assembly, and an access plate that are sequentially rotatably connected. The driving arm assembly includes a first driving arm and a second driving arm, where the first driving arm is rotatably mounted on the robotic arm bottom plate through a first active driving mechanism. The first driving arm is provided with a second active driving mechanism for driving the second driving arm, and the second driving arm can drive the relative rotation of the access plate through the driven linkage mechanism. The first active driving mechanism is placed outside the first driving arm, and the robotic arm bottom plate and the first active driving mechanism are disposed inside the lifting box. Through the layout of the driving mechanism and the design of the driven linkage mechanism, the compactness of the height and size of the robotic arm can be ensured, and the accessible position is lower. By designing special core-alignment tooling, the convenience of assembly and maintenance of the robotic arm can be improved.

## Description

### TECHNICAL FIELD

The various embodiments described in this document relate in general to the technical field of semiconductor stereoscopic warehouses, and more specifically to a semiconductor stacker, a robotic arm of the semiconductor stacker, and a method for operating the robotic arm.

### BACKGROUND

In a semiconductor fabrication facility (Fab), there are a huge number of wafer pods. Storing and handling of wafer pods are relatively important, and warehouses for the wafer pods are a type of equipment used to store and manage the wafer pods. The warehouse has a high-speed and high-precision stacker, a core part of the warehouse, inside the warehouse.

However, due to a limited available space of the warehouse and large storage requirements for the warehouse, the stacker has a larger number of handling tasks. In addition, there are also high requirements for the height and size of the robotic arm of the stacker. Therefore, the mechanical structure and operation mode of the stacker need to be optimized.

### SUMMARY

In view of the above, embodiments of the present disclosure provide a semiconductor stacker, a robotic arm of the semiconductor stacker, and a method for operating the robotic arm, which solve the problem of insufficient space utilization of the stacker of the warehouse for the wafer pods by utilizing a more compact driving layout of the robotic arm.

Embodiments of the present disclosure provide a robotic arm of a semiconductor stacker. The robotic arm includes a robotic arm bottom plate, a driving arm assembly, and an access plate. The driving arm assembly includes a first driving arm and a second driving arm. The first driving arm is rotatably mounted on the robotic arm bottom plate through a first active driving mechanism, the second driving arm is provided with a driven linkage mechanism inside the second driving arm, and the first driving arm is provided with a second active driving mechanism inside the first driving arm. The first active driving mechanism is configured as an independent power source to drive the first driving arm to rotate, and the second active driving mechanism is configured as an independent power source to drive the second driving arm to rotate relative to the first driving arm. In rotation of the second driving arm, the second driving arm drives the driven linkage mechanism to synchronously drive the access plate to rotate, such that extension and retraction of the access plate in a linear direction is controlled by rotating the first driving arm, the second driving arm, and the access plate according to a set manner.

In some embodiments, the set manner satisfies Δα₂ = Δα₁ + Δα₃ during the extension or the retraction of the access plate in the linear direction. Where, Δα₁ represents an amount of change in a rotation angle of the first driving arm with respect to ray extending in a X-axis direction on the robotic arm bottom plate, Δα₂ represents an amount of change in a rotation angle of the second driving arm with respect to the first driving arm, and Δα₃ represents an amount of change in a rotation angle of the access plate with respect to the second driving arm, such that the access plate can reach a specified target position.

Embodiments of the present disclosure further provide a method for operating a robotic arm of a semiconductor stacker, implemented by the robotic arm of the semiconductor stacker described in any embodiments of the disclosure. During the extension and the retraction of the access plate in the linear direction, the first driving arm, the second driving arm, and the access plate cooperate with each other to: enable the access plate to be gradually extended in the linear direction from the initial origin position according to a set manner Δα₂ = Δα₁ + Δα₃ until the access plate reaches a target storage position of the warehouse; and to enable the access plate to be gradually retracted in the linear direction according to the set manner Δα₂ = Δα₁ + Δα₃ until the access plate returns to the initial origin position, where α₁ represents an angle of the first driving arm with respect to ray extending in an X-axis direction on the robotic arm bottom plate, and Δα₁ represents an amount of change in a rotation angle at which the first driving arm rotates clockwise or counterclockwise with respect to the robotic arm bottom plate; α₂ represents an angle of the second driving arm with respect to the first driving arm, and Δα₂ represents an amount of change in a rotation angle at which the second driving arm rotates clockwise or counterclockwise with respect to the first driving arm; and α₃ represents an angle of the access plate with respect to the second driving arm, and Δα₃ represents an amount of change in a rotation angle at which the access plate rotates counterclockwise or clockwise with respect to the second driving arm.

Embodiments of the present disclosure further provide a semiconductor stacker including the robotic arm of the semiconductor stacker described in any embodiment of the disclosure, where the stacker further includes an upright column and the lifting box, the lifting box is slidably mounted on the upright column in a Z-axis direction, the upright column is provided with a traveling module at a bottom of the upright column, and the traveling module is slidably mounted on a horizontally disposed slide rail in an X-axis direction. In response to the robotic arm being at an initial origin position to perform an article taking-out task: the traveling module drives the stacker to move by a specified distance along the X-axis direction, the lifting box moves up and down by a specified distance along the Z-axis direction, a driving arm assembly of the robotic arm rotates to cause the access plate of the robotic arm to extend along a Y-axis direction to reach a designated storage position to take out the wafer pod, and to cause the access plate of the robotic arm to retract in a reverse direction to reach the initial origin position. In response to the robotic arm (carrying the corresponding wafer pod) being at the initial origin position to perform an article storing task: the traveling module drives the stacker to move by a specified distance along the X-axis direction, the lifting box moves up and down by a specified distance along the Z-axis direction, the driving arm assembly of the robotic arm rotates to cause the access plate of the robotic arm to extend in the Y-axis direction to place the wafer pod in a designated storage position, and to cause the access plate of the robotic arm to retract in a reverse direction to reach the initial origin position.

Embodiments of the present disclosure further provide an access method, implemented based on the robotic arm of the semiconductor stacker according to any embodiment of the present disclosure, and the access method includes a wafer pod taking-out process and a wafer pod storage process. The plurality of detection sensors disposed at different positions of the access plate detects at least one of whether there is the wafer pod on the storage position, whether there is the wafer pod on the access plate, a position of the access plate relative to the storage position, and whether there is the wafer pod on the storage position. A RFID reader provided at a front end of the access plate directly reads corresponding information of the wafer pod, in response to taking out the wafer pod from the storage position and storing the wafer pod into the storage position by the access plate.

### BRIEF DESCRIPTION OF THE DRAWINGS

In order to more clearly explain the technical solutions of the embodiments of the present disclosure, the accompanying drawings that need to be used in the embodiments will be briefly introduced below, and it is obvious that the accompanying drawings described in the following are merely some embodiments of the present disclosure, and other accompanying drawings can be obtained based on these accompanying drawings without creative efforts for those skilled in the art.
FIG. 1 is a perspective view of a robotic arm after being mounted to a lifting box according to an embodiment of the present disclosure.
FIG. 2 is a perspective view of a robotic arm according to an embodiment of the present disclosure.
FIG. 3 is a top view of a robotic arm according to an embodiment of the present disclosure.
FIG. 4 is a front view of a robotic arm according to an embodiment of the present disclosure.
FIG. 5 is a schematic diagram of a structural principle of a driving arm assembly according to an embodiment of the present disclosure.
FIG. 6 is a schematic structural diagram of a first driving arm, a second driving arm, and an access plate according to an embodiment of the present disclosure.
FIG. 7 is a schematic diagram of a process of moving the driving arm assembly from an initial origin position toward a target storage position of the warehouse according to an embodiment of the present disclosure.
FIG. 8 is a perspective view of a core alignment tooling in use according to an embodiment of the present disclosure.
FIG. 9 is a perspective view of a second bolt in use according to an embodiment of the present disclosure.
FIG. 10 is a perspective view of a stacker according to an embodiment of the present disclosure.
FIG. 11 is a schematic structural diagram of a stacker according to an embodiment of the present disclosure.
FIG. 12 is a perspective view of a plurality of sensors on the access plate according to an embodiment of the present disclosure.
FIG. 13 is a schematic structural diagram of a first sensor and a second sensor that sense a reflective plate according to an embodiment of the present disclosure.
FIG. 14 is a flow chart of taking out a wafer pod from a storage position of the warehouse according to an embodiment of the present disclosure.
FIG. 15 is a flow chart of storing a wafer pod into a storage position of the warehouse according to an embodiment of the present disclosure.
FIG. 16 is a top view of an access plate and a storage position according to related technologies.
FIG. 17 is a front view of an access plate and a storage position according to the related technologies.
FIG. 18 is a schematic diagram of a projection of a detection light of the sensor exceeding an upper edge of the reflective plate according to the related technologies.
FIG. 19 is a schematic diagram of a projection of the detection light of the sensor exceeding a lower edge of the reflective plate according to the related technologies.
FIG. 20 is a schematic diagram of a projection of the detection light of the sensor on a central position of the reflective plate according to the related technologies.
FIG. 21 is a perspective view of a robotic arm and a lifting box according to an embodiment of the present disclosure.
FIG. 22 is a perspective view of a robotic arm according to an embodiment of the present disclosure.
FIG. 23 is a perspective view of an access plate according to an embodiment of the present disclosure.
FIG. 24 is a perspective view of an access plate carrying a wafer pod according to an embodiment of the present disclosure.
FIG. 25 is a schematic structural diagram of a reflective plate according to an embodiment of the present disclosure.
FIG. 26 is a schematic view of a back surface of the access plate according to an embodiment of the present disclosure.

### DETAILED DESCRIPTION OF THE EMBODIMENTS

Hereinafter, embodiments of the present disclosure will be described in detail with reference to the accompanying drawings.

Hereinafter, embodiments of the present disclosure will be described with specific examples, and those skilled in the art will readily understand other advantages and effects of the present disclosure from the disclosure of the present specification. Obviously, the described embodiments are only a part of the embodiments of the present disclosure, rather than all the embodiments. The present disclosure can also be implemented or applied by other different specific embodiments, and various details in the present specification can also be modified or changed based on different viewpoints and applications without departing from the spirit of the present disclosure. It is to be noted that the following embodiments and features in the embodiments may be combined with each other without conflict. Based on the embodiments in the present disclosure, all other embodiments obtained by those skilled in the art without creative efforts fall within the scope of protection of the present disclosure.

It is to be noted that various aspects of embodiments that are within the scope of the appended claims are described below. It should be apparent that the aspects described herein may be embodied in a wide variety of forms, and that any particular structure and/or function described herein is illustrative only. Based on the present disclosure, those skilled in the art will appreciate that one aspect described herein can be implemented independently of any other aspect, and that two or more of these aspects can be combined in various ways. For example, the apparatus can be implemented and/or the method can be practiced using any number and aspects set forth herein. Additionally, the apparatus may be implemented and/or the method may be practiced using other structures and/or functionalities in addition to one or more of the aspects set forth herein.

It is also be noted that the drawings provided in the following examples only illustrate the basic concept of the present disclosure in a schematic manner, and only the components related to the present disclosure are shown in the drawings instead of drawing according to the number, shape and size of the components in actual implementation, and the type, number and proportion of each component in actual implementation may be arbitrarily changed, and the layout of the components may also be more complicated.

In addition, in the following description, specific details are provided to facilitate a thorough understanding of the examples. However, those skilled in the art will appreciate that the disclosure may be practiced without these specific details.

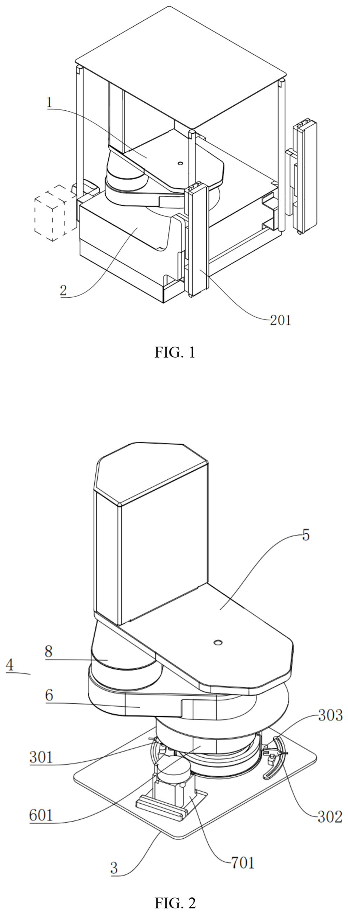

Referring to FIGS. 1 to 7, a robotic arm of a semiconductor stacker is provided in embodiments of the disclosure. A robotic arm 1 is mounted on a lifting box 2. The robotic arm 1 includes a robotic arm bottom plate 3, a driving arm assembly 4, and an access plate 5. The robotic arm bottom plate 3 is configured to carry the driving arm assembly 4. The driving arm assembly 4 is configured to move the access plate 5 in a linear direction (e.g., to store a target wafer pod(s) into a target storage position 17 of a warehouse or to take out the target wafer pod from the target storage position 17). The driving arm assembly 4 includes a first driving arm 6 and a second driving arm 8. The first driving arm 6 is rotatably mounted on the robotic arm bottom plate 3 through a first active driving mechanism 7. The second driving arm 8 is provided with a driven linkage mechanism 10 inside the second driving arm 8, and the first driving arm 6 is provided with a second active driving mechanism 9 inside the first driving arm 6.

The first active driving mechanism 7, the second active driving mechanism 9, and the driven linkage mechanism 10 have following functions. The first active driving mechanism 7 is configured as an independent power source, to drive the first driving arm 6 to rotate. The second active driving mechanism 9 is configured as an independent power source, to drive the second driving arm 8 to rotate relative to the first driving arm 6. In rotation of the second driving arm 8, the second driving arm 8 drives (i.e., the rotation of the second driving arm 8 functions as a power source) the driven linkage mechanism 10 to synchronously drive the access plate 5 to rotate. That is, a power source of the access plate 5 comes from the rotation of the second driving arm 8, and thus, there is no need to provide an additional driving power source (e.g., a driving motor) to drive the access plate 5 to rotate, which can further reduce a height and a size of the robotic arm in a vertical direction. By controlling rotation of the first driving arm 6, the second driving arm 8, and the access plate 5 according to a set manner, extension and retraction of the access plate 5 in a Y-axis linear direction can be achieved.

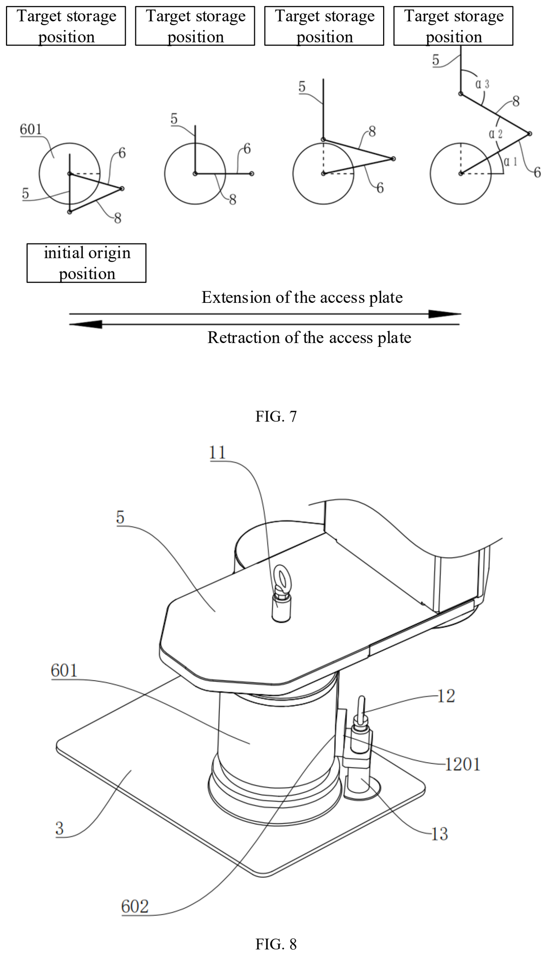

In one example, as shown in FIG. 7, the set manner satisfies Δα₂ = Δα₁ + Δα₃ during the extension or retraction of the access plate 5 in a linear direction, where Δα₁ represents an amount of change in a rotation angle of the first driving arm with respect to ray extending in a X-axis direction on the robotic arm bottom plate, Δα₂ represents an amount of change in a rotation angle of the second driving arm 8 with respect to the first driving arm 6, and Δα₃ represents an amount of change in a rotation angle of the access plate 5 with respect to the second driving arm 8, so that the access plate 5 can reach a predetermined target position.

Specifically, during the extension of the access plate 5 in the linear direction (switching from a retracted state at an initial origin position to an extended state), the amount of the change Δα₂ in the rotation angle at which the second driving arm 8 rotates clockwise with respect to the first driving arm 6 is equal to the sum of the amount of the change Δα₃ in the rotation angle at which the access plate 5 rotates counterclockwise with respect to the second driving arm 8 and the amount of the change Δα₁ in the rotation angle at which the first driving arm 6 rotates counterclockwise with respect to the ray extending in the X-axis direction on the robotic arm bottom plate 3. On the other hand, during the retraction of the access plate 5 in the linear direction (switching from the extended state to the retracted state at the initial origin position), the amount of change Δα₂ in the rotation angle at which the second driving arm 8 rotates counterclockwise with respect to the first driving arm 6 is equal to the sum of the amount of change Δα₃ in the rotation angle at which the access plate 5 rotates clockwise with respect to the second driving arm 8 and the amount of change Δα₁ in the rotation angle at which the first driving arm 6 rotates clockwise with respect to ray extending in the X-axis direction on the robotic arm bottom plate 3.

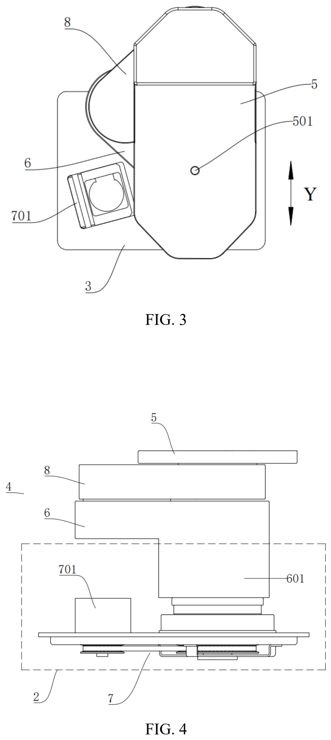

In some embodiments, as shown in FIG. 4, the first driving arm 6 is provided with a rotating seat 601 extending downward from a bottom of an arm body of the first driving arm 6 and connected to the first active driving mechanism 7. The second active driving mechanism 9 is partially disposed in the rotating seat 601. The first active driving mechanism 7 is disposed outside the first driving arm 6. The robotic arm bottom plate 3, the rotating seat 601, and the first active driving mechanism 7 are disposed in the lifting box 2. The arm body of the first driving arm 6, the second driving arm 8, and the access plate 5 are provided outside the lifting box 2 in the vertical direction, which further limit the height and the size of the entire robotic arm 1.

Since the stereoscopic warehouse has a relatively small available space in the related technologies, in the present disclosure, by rearranging power driving mechanisms of the two driving arms of the robotic arm 1, the compactness of the height and the size of the robotic arm can be ensured, a space utilization rate of the device is relatively larger, and the accessible position is lower, so that the lowermost access position is as low as possible. In addition, the extension and retraction of the access plate in the Y-axis direction can be achieved by mutually rotating the first driving arm, the second driving arm, and the access plate.

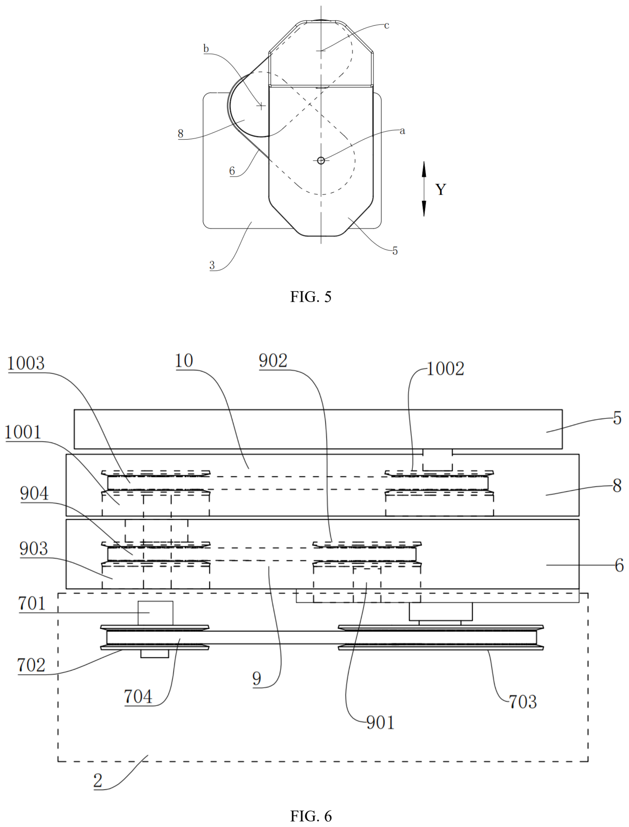

As shown in FIGS. 5 and 6, a first rotation point *a* is formed between the first driving arm 6 and the robotic arm bottom plate 3, a second rotation point b is formed between the first driving arm 6 and the second driving arm 8, and a third rotation point c is formed between the second driving arm 8 and the access plate 5, such that the extension and retraction of the access plate 5 in the Y-axis direction are finally realized by the rotation of the first driving arm 6, the second driving arm 8, and the access plate 5. A connecting line between the first rotation point and the third rotation point c is collinear with a symmetrical center line of the access plate. The symmetrical center line of the access plate 5 is parallel to a linear movement direction of the access plate 5. As shown in FIGS. 4 to 7, the symmetrical center line of the access plate 5 always passes through a center of rotation of the rotating seat 601.

In some embodiments, as shown in FIG. 6, the driven linkage mechanism 10 includes a first fixed wheel 1001 fixed in the second driving arm 8 and a third driven wheel 1002 rotatably mounted in the second driving arm 8. The first fixed wheel 1001 and the third driven wheel 1002 are, rotatably and synchronously, connected with each other. There is no relative rotation between the first fixed wheel 1001 and the second driving arm 8. The first fixed wheel 1001 is located at the second rotation point b, and the third driven wheel 1002 is located at the third rotation point c, where the third driven wheel 1002 is configured to drive the access plate 5 to rotate synchronously (for example, the third driven wheel 1002 may be connected to the access plate 5 through a reducer for deceleration). The driven linkage mechanism 10 is not configured with a driving motor with an active drive. The driven linkage mechanism 10 is configured to drive the third driven wheel 1002 to rotate through rotation of the second driving arm 8, and the rotation of the third driven wheel 1002 finally realizes the rotation of the access plate 5 relative to the second driving arm 8.

The first fixed wheel 1001 and the third driven wheel 1002 may be connected by a conveyor belt to implement a transmission connection, or may be connected by meshing of a multi-stage gear or the like to implement a transmission connection. As shown in FIG. 6, the first fixed wheel 1001 and the third driven wheel 1002 of the present disclosure are synchronously connected by a third conveyor belt 1003.

In some embodiments, the first active driving mechanism 7 includes a first driving motor 701 mounted on the robotic arm bottom plate 3, a first drive wheel 702 mounted on the first driving motor 701, and a first driven wheel 703 rotatably connected with the first drive wheel 702 synchronously. The first driven wheel 703 is located at the first rotation point *a,* and the first driven wheel 703 is configured to drive the first driving arm 6 to rotate (for example, the first driven wheel 703 may be connected with the first driving arm 6 through a reducer for deceleration). The first drive wheel 702 and the first driven wheel 703 are disposed at a bottom of the robotic arm bottom plate 3, a motor shaft of the first driving motor 701 passes through the robotic arm bottom plate 3, and a motor body part of the first driving motor 701 is mounted on the robotic arm bottom plate 3.

The first drive wheel 702 and the first driven wheel 703 may be connected through a conveyor belt to implement a transmission connection, or may be connected by meshing of a multi-stage gear or the like to implement a transmission connection. As shown in FIG. 6, the first drive wheel 702 and the first driven wheel 703 of the present disclosure are connected by a first conveyor belt 704 to operate synchronously.

In some embodiments, the second active driving mechanism 9 includes a second driving motor 901 disposed in the rotating seat 601, a second drive wheel 902 mounted on the second driving motor 901, and a second driven wheel 903 rotatably connected synchronously with the second drive wheel 902. The second driven wheel 903 is located at the second rotation point b. The second driven wheel 903 is connected with the first fixed wheel 1001 to drive the second driving arm 8 (for example, the second driven wheel 903 may be connected with the first fixed wheel 1001 by a reducer for deceleration) to rotate. The second driven wheel 903 synchronously drives the first fixed wheel 1001 to rotate, so as to cause the second driving arm 8 to rotate relative to the first driving arm 6.

The second drive wheel 902 and the second driven wheel 903 may be connected through a conveyor belt to implement a transmission connection, or may be connected by meshing of a multi-stage gear or the like to implement a transmission connection. As shown in FIG. 6, the second drive wheel 902 and the second driven wheel 903 are connected by a second conveyor belt 904 to operate synchronously.

In some embodiments, as shown in FIG. 2, the robotic arm bottom plate 3 is provided with a first limit sensor 301 and a second limit sensor 302 on the robotic arm bottom plate 3, and the first limit sensor 301 and the second limit sensor 302 are configured for limiting the rotation angle of the first driving arm 6. Therefore, a maximum rotation angle of the first driving arm 6 is limited through the two limit sensors. The rotating seat 601 is provided with a sensor detection sheet 303.

In some embodiments, as shown in FIGS. 3, 8, and 9, the first driving arm 6 is provided with a positioning plane 602 for quick core-alignment on an outer side of the first driving arm 6, and the access plate 5 defines a first core alignment hole 501 for quick core-alignment. The rotating seat 601 defines a second core alignment hole 603 corresponding to the first core alignment hole 501, where the second core alignment hole 603 is disposed coaxially with the first rotation point *a*.

Based on the same inventive concept, embodiments of the present disclosure further provide a method for operating the robotic arm of the semiconductor stacker, which is realized based on the robotic arm of the semiconductor stacker according to any of the above embodiments. As shown in FIG. 7, during extension and retraction of the access plate 5 in the linear direction, the first driving arm 6, the second driving arm 8, and the access plate 5 cooperate with each other to enable the access plate 5 to be gradually extended in the linear direction from the initial origin position according to a set manner Δα₂ = Δα₁ + Δα₃ until the access plate 5 reaches a target storage position of the warehouse. Thereafter, the access plate 5 is gradually retracted in the linear direction according to the set manner Δα₂ = Δα₁ + Δα₃ until the access plate 5 returns to the initial origin position.

In the above condition, α₁ represents an angle of the first driving arm with respect to the ray extending in the X-axis direction on the robotic arm bottom plate, Δα₁ represents an amount of change in a rotation angle at which the first driving arm rotates counterclockwise or clockwise with respect to the ray extending in the X-axis direction on the robotic arm bottom plate, α₂ represents an angle of the second driving arm with respect to the first driving arm, Δα₂ represents an amount of change in a rotation angle at which the second driving arm rotates clockwise or counterclockwise with respect to the first driving arm, α₃ represents an angle of the access plate with respect to the second driving arm, and Δα₃ represents an amount of change in a rotation angle at which the access plate rotates counterclockwise or clockwise with respect to the second driving arm. As shown in FIG. 7, when the access plate 5 is switched from the retracted state to the extended state in the linear direction (Y-axis direction), the first driving arm 6 rotates counterclockwise with respect to the robotic arm bottom plate 3, the second driving arm 8 rotates clockwise with respect to the first driving arm 6, and the access plate 5 rotates counterclockwise with respect to the second driving arm 8. When the access plate 5 is switched from the extended state to the retracted state in the linear direction (Y-axis direction), the first driving arm 6 rotates clockwise with respect to the ray extending in the X-axis direction on the robotic arm bottom plate 3, the second driving arm 8 rotates counterclockwise with respect to the first driving arm 6, and the access plate 5 rotates clockwise with respect to the second driving arm 8.

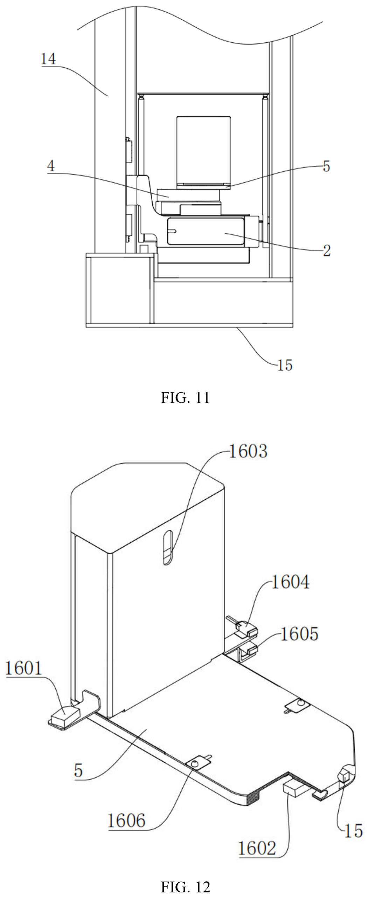

In order to enable the access plate 5 to accurately store the wafer pod into the storage position 17 of the warehouse or take out the wafer pod from the storage position 17 of the warehouse, it is necessary to ensure that the operation of the robotic arm 1 is accurate, and to further monitor a position and a state of the access plate 5, where the position of the access plate 5 on the robotic arm 1 is the key to ensure the smooth transportation of the wafer pod. In some embodiments, as shown in FIG. 12, the access plate 5 is provided with a radio frequency identification (RFID) reader 15 and a plurality of detection sensors. The plurality of detection sensors include a first sensor 1601, a second sensor 1602, a third sensor 1603, a fourth sensor 1604, a fifth sensor 1605, and at least one sixth sensor 1606. The first sensor 1601 is disposed at a left side end of the access plate 5, and the second sensor 1602 is disposed at a front side of the access plate 5. The third sensor 1603 is inclined downward and faces a plate surface of the access plate 5, and the at least one sixth sensor 1606 is disposed on a plate surface of the access plate 5. The fourth sensor 1604 and the fifth sensor 1605 are provided at a right side end of the access plate 5. The fourth sensor 1604 is disposed above the fifth sensor 1605. The first sensor 1601 and the second sensor 1602 are reflective photoelectric sensors. The sixth sensor 1606 is a micro switch sensor, and the third sensor 1603 is a reflective photoelectric sensor. The fourth sensor 1604 and the fifth sensor 1605 are reflective laser sensors. When the access plate 5 needs to take out the wafer pod from the storage position 17 of the warehouse, the access plate 5 lifts the wafer pod from below a plate surface of the storage position 17 of the warehouse, so as to take out the wafer pod. When the access plate 5 needs to store the wafer pod into the storage position 17 of the warehouse, the wafer pod is lowered from above the plate surface of the storage position 17 of the warehouse to be placed on the plate surface of the storage position 17 of the warehouse. Therefore, a designated position for waiting for article taking-out of the access plate 5 and a designated position for waiting for article-storing of the access plate 5 can be detected through the fourth sensor 1604 and the fifth sensor 1605 respectively, thereby improving the detection accuracy.

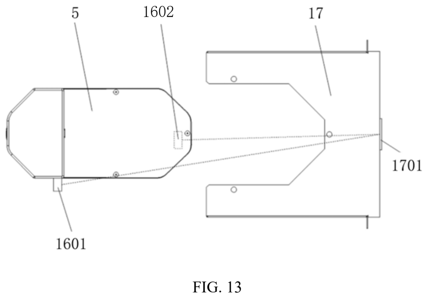

As shown in FIGS. 12 and 13, both the first sensor 1601 and the second sensor 1602 correspond to the reflective plate 1701 on the storage position 17 of the warehouse. The first sensor 1601 is configured to detect whether there is a corresponding wafer pod in the storage position 17 of the warehouse in response to performing an operation of taking out the wafer pod from the storage position 17 of the warehouse by the access plate 5. Specifically, by irradiating light from the first sensor 1601 onto the reflective plate 1701 of the storage position 17 of the warehouse, if no light returns, it indicates that there is the corresponding wafer pod in the storage position 17 of the warehouse. The second sensor 1602 is configured to detect whether there is no wafer pod in the storage position 17 of the warehouse in response to storing a wafer pod into the storage position 17 of the warehouse by the access plate 5. Specifically, by irradiating the light from the second sensor 1602 onto the reflective plate 1701 of the storage position 17 of the warehouse, if the light returns, it indicates that there is no wafer pod into the storage position 17 of the warehouse, such that the wafer pod can be stored. The third sensor 1603 is configured to detect whether there is a wafer pod currently on the access plate 5 (detection of storing and taking out of the wafer pod need to be performed by the third sensor 1603). The sixth sensor 1606 is configured to detect a state of the wafer pod on the current access plate 5. When the wafer pod is taken out from the storage position 17 of the warehouse, the sixth sensor 1606 detects whether the wafer pod is put in place, and after the wafer pod is placed in the storage position 17 of the warehouse, the sixth sensor 1606 detects whether there is no wafer pod on the access plate 5. The fourth sensor 1604 is configured to detect whether a current position of the current access plate 5 relative to the storage position 17 of the warehouse is correct in response to performing the operation of taking out the wafer pod from the storage position 17 of the warehouse by the access plate 5. The fifth sensor 1605 is configured to detect whether a current position of the current access plate 5 relative to the storage position 17 of the warehouse is correct in response to performing the operation of storing a wafer pod into the storage position 17 of the warehouse by the access plate 5.

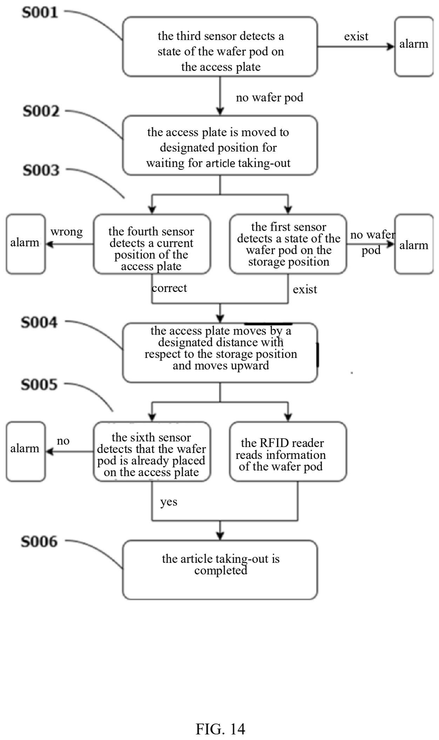

As shown in FIG. 14, the method of taking out the wafer pod from the storage position 17 of the warehouse by the access plate 5 of the robotic arm can be performed as follows.

At S001, the third sensor 1603 detects a state of the wafer pod on the access plate 5. The third sensor 1603 detects whether there is no wafer pod on the plate surface of the access plate 5. If there is a wafer pod on the plate surface of the access plate 5, an alarm is issued. If there is no wafer pod on the plate surface of the access plate 5, it indicates that there is no wafer pod on the current access plate 5, allowing the access plate 5 to take out the wafer pod from the storage position 17 of the warehouse. At S002, the access plate 5 is moved to the designated position for waiting for article taking-out. The access plate 5 is moved to the designated position for waiting for article taking-out in front of the storage position 17 of the warehouse. At S003, the fourth sensor 1604 detects a current position of the access plate 5, and the first sensor 1601 detects a wafer pod state on the storage position 17 of the warehouse. The fourth sensor 1604 detects whether the access plate 5 is located at the designated position for waiting for article taking-out of the access plate 5 relative to the storage position 17 of the warehouse. If the access plate 5 is not located at the designated position, an alarm is issued. The first sensor 1601 simultaneously detects whether there is the wafer pod on the storage position 17 of the warehouse. It there is no wafer pod on the storage position 17 of the warehouse, an alarm is issued. At S004, the access plate 5 is moved by a predetermined distance with respect to the storage position 17 of the warehouse and moves upward. The access plate 5 enters the storage position 17 of the warehouse and rises to lift the corresponding wafer pod. At S005, the sixth sensor 1606 detects that the wafer pod has been placed on the access plate 5, and the RFID reader reads information of the current wafer pod. The sixth sensor 1606 on the access plate 5 detects whether the currently lifted wafer pod is put in place. If the currently lifted wafer pod is not put in place, an alarm is issued. The RFID reader on the access plate 5 reads the information of the current wafer pod. At S006, the access plate 5 is retracted, such that the operation of article taking-out is completed. The access plate 5 is retracted and reset, and the article taking-out is completed.

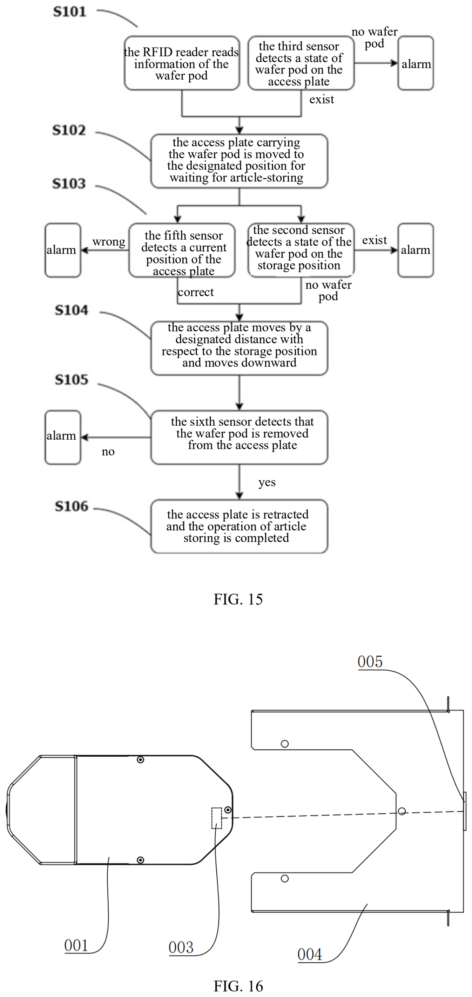

As shown in FIG. 15, the method of storing the wafer pod carried in the access plate 5 of the robotic arm in the storage position 17 of the warehouse can be performed as follows.

At S101, the third sensor 1603 detects a state of the wafer pod on the access plate 5, and the RFID reader reads information of the wafer pod currently on the access plate 5. The third sensor 1603 detects whether there is a wafer pod on the access plate 5. If not, an alarm is issued. The RFID reader on the access plate 5 reads information of the wafer pod currently on the access plate 5. At S102, the access plate 5 carrying the wafer pod is moved to the designated position for waiting for article-storing. The access plate 5 carrying the corresponding wafer pod is moved to the designated position for waiting for article-storing in front of the storage position 17 of the warehouse. At S103, the fifth sensor 1605 detects a current position of the access plate 5, and the second sensor 1602 detects a wafer pod state of the storage position 17 of the warehouse. The fifth sensor 1605 detects the designated position of the designated position for waiting for article-storing of the access plate 5 relative to the storage position 17 of the warehouse. If the position is wrong, an alarm is issued. The second sensor 1602 on the access plate 5 simultaneously detects whether there is no wafer pod on the storage position 17 of the warehouse. If there is a wafer pod on the storage position 17, an alarm is issued. At S104, the access plate 5 is moved by a predetermined distance with respect to the storage position 17 of the warehouse and moves downward. The access plate 5 enters the storage position 17 of the warehouse and moves downward to place the corresponding wafer pod. At S105, the sixth sensor 1606 detects whether the wafer pod is taken out from the access plate 5. The sixth sensor 1606 on the access plate 5 detects whether the wafer pod has been taken out from the access plate 5, and if not, an alarm is issued. At S106, the access plate 5 is retracted, and the operation of article storing is completed. The access plate 5 is retracted and reset, and the operation of article storing is completed.

It is to be pointed out that on the basis of reducing the height and the size of the robotic arm as a whole, the present disclosure improves the position detection accuracy of the access plate of the robotic arm through the relative rotation of the first driving arm, the second driving arm, and the access plate 5 and the configuration of sensors with different positions and numbers. In addition, on the basis of the stability of the detection, the RFID reader is disposed on the access plate 5, reading and taking-out/storing can be concurrently achieved, such that the access plate 5 can take out or store the wafer pod quickly and accurately.

It is worth noting that the sixth sensor may be a displacement sensor, such as the micro switch sensor mentioned above, and whether the wafer pod is in place can be determined by a pressed state. The fourth/fifth sensors may be reflective sensors, such as laser reflective sensors mentioned above, and configured for position detection. The first sensor, the second sensor, and the third sensor may be reflective sensors, such as photoelectric sensors mentioned above, and configured for detecting a state of items, e.g., determining whether there is an item. The above laser reflective sensor and the photoelectric sensor can be universally used (i.e., used interchangeably). However, in the embodiments of the present disclosure, considering that the first sensor, the second sensor, and the third sensor directly emit light to detect the wafer pod, in order to ensure safety and prevent damage to the wafer pod or the wafer sheet inside the wafer pod, the use of the laser sensor is avoided. However, there is no restriction on the specific sensors mentioned above, and all sensors capable of implementing the detection function should fall within the scope of protection of the present disclosure.

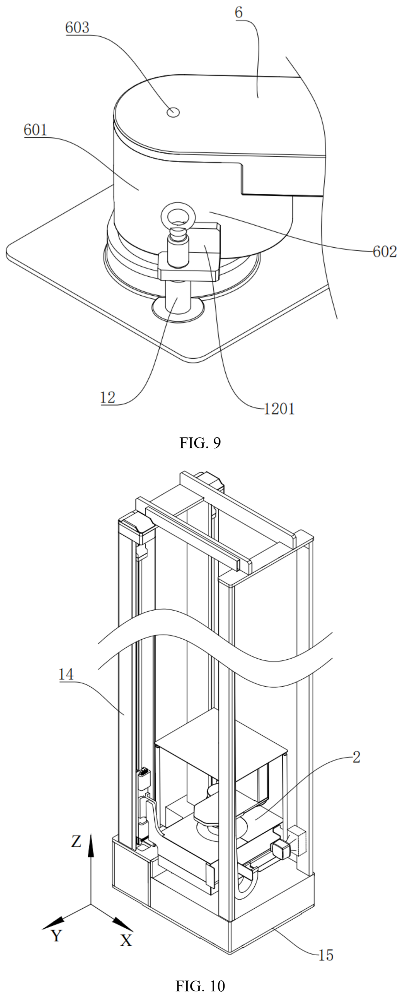

Since it is necessary to correct the initial origin position of the robotic arm during assembly, embodiments of the present disclosure further provide a core alignment tooling of the robotic arm of the semiconductor stacker based on the same inventive concept. As shown in FIGS. 8 and 9, the core alignment tooling includes a first bolt 11, a second bolt 12, and a holed bracket 13 provided on the robotic arm bottom plate 3, where the second bolt 12 is provided with a rest block 1201. Performing packing the robotic arm to the initial origin position includes performing packing the access plate 5 to the initial origin position and performing packing the first driving arm 6 to the initial origin position. Each of the first bolt 11 and the second bolt 12 is provided with a pull ring to facilitate installation and disassembly of the two bolts.

When performing packing the access plate 5 to the initial origin position, the first bolt 11 is sequentially coaxially inserted into the first core alignment hole 501 of the access plate 5 and the second core alignment hole 603 of the rotating seat 601 to realize packing of the initial origin position. When performing packing the first driving arm 6 to the initial origin position, the second bolt 12 is inserted into the holed bracket 13, to enable that a positioning plane 602 on the outer side of the first driving arm 6 abuts on the rest block 1201 to realize packing of the initial origin position.

In other words, during initial assembly or during resumption after maintenance, or in order to facilitate storage and transportation of the robotic arm, the access plate and the rotating seat are locked, so that the first driving arm and the robotic arm bottom plate, the first driving arm and the second driving arm, and the second driving arm and the access plate are respectively in a preset positional relationship, so that the entire robotic arm is in a state where the occupied space is minimized. Specifically, the robotic arm further includes the first bolt 11, the second bolt 12, the rest block 1201, and the holed bracket 13 fixedly mounted on the robotic arm bottom plate. The first driving arm is provided with the positioning plane 602 on the outer side of the first driving arm. The first bolt 11 is inserted into the first core alignment hole 501 and the second core alignment hole 603 that are coaxially disposed to lock the access plate 5 and the rotating seat 601. The second bolt 12 is inserted into a hole of the holed bracket 13 after passing through the rest block 1201, and the rest block 1201 is fixedly mounted on the positioning plane 602 to lock the first driving arm 6 and the robotic arm bottom plate 3. For example, the rest block 1201 is mounted or fixed to the positioning plane 602 by screws or the like, and the holed bracket 13 is mounted or fixed to the robotic arm bottom plate 3 by screws or the like.

Based on the same inventive concept, embodiments of the present specification further provide a semiconductor stacker including the robotic arm of the semiconductor stacker according to any of the aforementioned embodiments. As shown in FIGS. 10 and 11, the stacker further includes an upright column 14 and a lifting box 2. The lifting box 2 is slidably mounted on the upright column 14 along the Z-axis direction by a slider assembly 201. A pulley mechanism is connected to the lifting box 2, and a conveyor belt of the pulley mechanism acts as a main force to drive the lifting box 2 to perform lifting movement. The upright column 14 is provided with a traveling module 15 at the bottom of the upright column 14. The traveling module 15 is slidably mounted on a horizontally disposed slide rail in the X-axis direction, where the slide rail is disposed at the bottom of the warehouse where the stacker is located.

In FIG. 10, the X-axis direction is a moving direction of the stacker, the Y-axis direction is a moving direction of the access plate 5 of the robotic arm, and the Z-axis direction is a lifting moving direction of the lifting box 2.

When the robotic arm 1 is at the initial origin position to perform an article taking-out task: the traveling module 15 drives the whole stacker to move by a specified distance along the X-axis direction, the lifting box 2 moves up and down by a specified distance along the Z-axis direction, the driving arm assembly 4 of the robotic arm 1 rotates to cause the access plate 5 of the robotic arm 1 to extend along the Y-axis direction to reach a designated storage position to take out the wafer pod, and then to cause the access plate 5 of the robotic arm 1 to retract in a reverse direction to reach the initial origin position.

When the robotic arm 1 carrying the wafer pod is located at the initial origin position to perform an article-storing task: the traveling module 15 drives the whole stacker to move by a specified distance along the X-axis direction, the lifting box 2 moves up and down by a specified distance along the Z-axis direction, the driving arm assembly 4 of the robotic arm 1 rotates to cause the access plate 5 of the robotic arm 1 to extend in the Y-axis direction to place the wafer pod in a designated storage position, and then to cause the access plate 5 of the robotic arm 1 to retract in a reverse direction to reach the initial origin position.

The existing stacker is affected by the warehouse (an operable space reserved for the stacker to access the wafer pod is very limited in the warehouse aisle, and storage positions, etc.), and thus, the requirements for detection accuracy of the sensors, and for reading speed of the RFID sensor and storage quantity are as follows in terms of layout of the sensors. 1. A fork of the robotic arm relative to a storage position of the warehouse need to have various accurate detection functions during access of the wafer pod, for example, need to detect whether there is a wafer pod on the fork, to detect whether there is a wafer pod on the storage position, and to detect a position of the fork relative to the storage position, etc., which all require a relatively high detection accuracy. 2. The speed of RFID reader reading the information of the wafer pod needs to be fast. 3. The weight of the equipment needs to be reduced as much as possible and the running speed needs to be improved.

Therefore, the existing stackers suffer more or less from the following problems.
1) False detection of the sensor may occur due to problems of the layout of sensors of the fork, which may easily cause damage to the wafer pod during movement of the equipment. A scanning range of the sensor is affected by factors such as blocking of light by the installation hole and blocking of light by the bottom of the wafer pod, and thus, the requirements for detection range and detection position of the sensor is relatively high, which is relatively difficult to debug, thus easily causing the false detection.

Referring to FIG. 16, in the related technologies, when the access plate 001 of the robotic arm of the stacker stores the wafer pod 002 into the storage position of the warehouse or takes out the wafer pod 002 from the storage position, only the sensor 003 is used to perform position detection. That is, the sensor 003 is used to emit a detection light 006 to the reflective plate 005 on the storage position 004. When no light returns, it is determined that there is the wafer pod 002 on the current storage position 004. When light returns, it is determined that there is no wafer pod 002 on the current storage position 004.

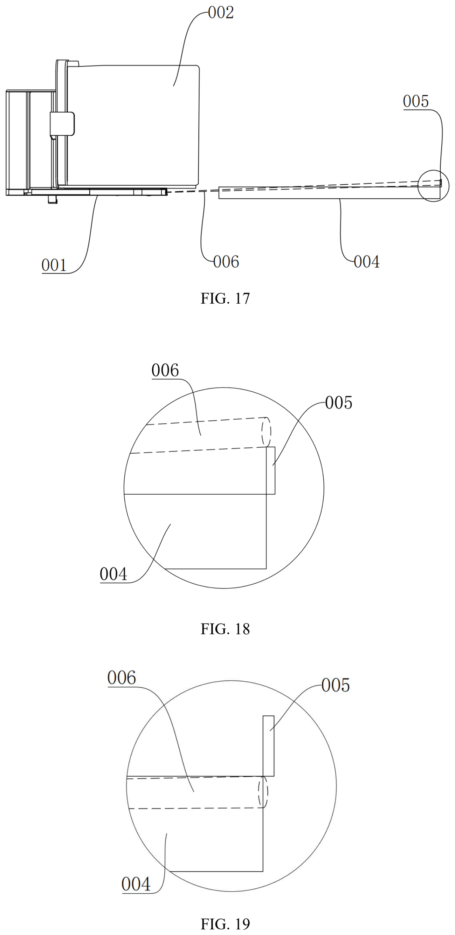

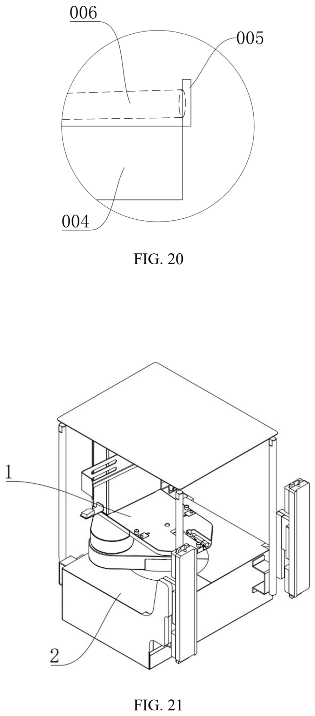

FIGS. 17 to 20 illustrate a relative position of an end light and the reflective plate when only the sensor 003 on the access plate is used to detect a wafer pod state of the plate surface of the storage position 004. As shown in FIGS. 18 and 19, the light may fall on an upper side or lower side of the reflective plate, or exceed the upper side or lower side, thereby causing false detection, and resulting in subsequent erroneous execution. As shown in FIG. 20, an accurate detection result may be obtained only when the light accurately falls on an effective plate surface range of the reflective plate.

However, due to the limited internal space of the warehouse and the guarantee of high accuracy, the size of the reflective plate 005 is limited. In addition, when there are an installation error of the reflective plate 005, a debugging error generated during demonstrating, and an error of a stopping position of the robotic arm, the detection light of the sensor 003 may deviate from the range of the reflective plate 005, it may cause no light to return, thus misjudging a wafer pod state of the current storage position 004. Since it is difficult to detect how errors are generated, in order to reduce the error, manual labor faces tremendous pressure in installing reflective plates, and teaching and debugging the operation of stacker, etc.

2) In addition, the existing radio frequency identification (RFID) sensor is generally placed on a certain storage position, and thus information reading is achieved only when the stacker put the wafer pod on the storage position, which is serious in time-consuming and leads to slow reading speed of the RFID sensor.

3) The robotic arm of the stacker is relatively heavy and thus it is difficult to increase the running speed.

In view of the above, embodiments of the present disclosure provide a robotic arm of a semiconductor stacker and an access method for the robotic arm, which may improve detection accuracy and detection speed by configuring different positions and numbers of sensors. In addition, the RFID reader is directly disposed on an access plate, so as to solve technical problems of such as damage to a wafer pod and slow reading speed of the RFID reader during movement of the equipment that may be caused by false detection of the sensor.

In the method of storing and taking out of the wafer pod by the robotic arm according to the embodiments of the present disclosure, accurate and rapid detection is realized by configuring different positions and numbers of sensors. In particular, the wafer pod on the storage position of the warehouse is separately detected by the first sensor and the second sensor separately disposed. Through the separately provided third sensor, the presence or absence of the wafer pod on the access plate can be separately detected when the wafer pod is stored or taken out, so as to avoid the possibility of misjudgment. Therefore, the detection accuracy can be improved, and the influence of manual assembly errors and the difficulty of machine debugging can be reduced.

In the embodiments of the present disclosure, on the basis of using the sensor for detection to ensure detection stability, since the RFID reader is also provided on the access plate, the effect of taking out/storing and reading concurrently can be realized.

In addition, by lightweighting the access plate and reducing the influence of the weight of the access plate on the running speed as much as possible, the performance of the equipment can be improved.

Referring to FIGS. 21 to 26, embodiments of the present disclosure provide a robotic arm 1 of a semiconductor stacker. The robotic arm 1 is mounted on a lifting box 2 of the stacker, the lifting box 2 is slidably mounted on an upright column of the stacker, and the lifting box 2 is slidable relative to the stacker in a vertical direction. The robotic arm 1 is configured to store the wafer pod 40 into the storage position 30 of the warehouse or take out the wafer pod 40 from the storage position 30. The robotic arm 1 includes an access plate 5 for carrying the wafer pod 40 and a driving mechanism 60 for driving the access plate 5 to move, where the access plate 5 is mounted on the lifting box 2 through the driving mechanism 60. The driving mechanism 60 is an articulated arm, including a rotatable primary articulated arm and secondary articulated arm. Extension and retraction of the access plate 5 in a linear direction are achieved through change of rotational linkage between the articulated arms, to store the wafer pod 40 into the storage position 30 of the warehouse or take out the wafer pod 40 from the storage position 30.

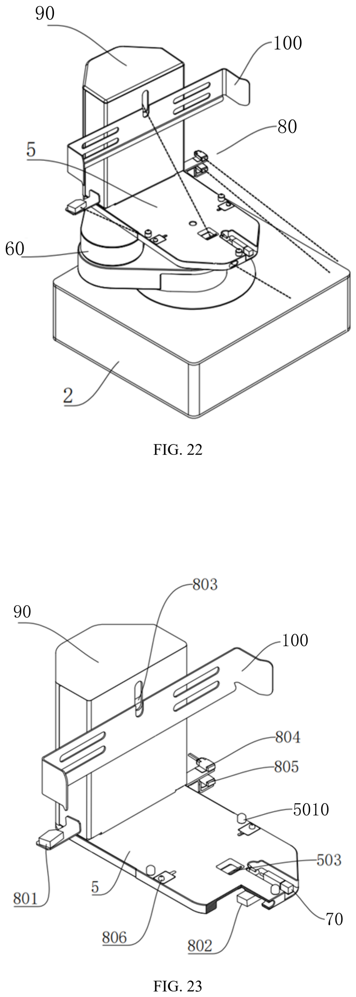

As shown in FIGS. 22 and 23, an RFID reader 70 for directly reading information of the wafer pod 40 and a plurality of detection sensors 80 are mounted on the access plate 5.

Since the RFID reader 70 is directly disposed on the access plate 5, there is no need to move the wafer pod to a predetermined position for information reading and identifying as in the conventional stacker, which may save the overall handling time and improve the conveyance efficiency. The RFID reader 70 can read and identify the information of the wafer pod when the wafer pod is stored in the access plate 5 or when the access plate 5 takes out the wafer pod, thereby achieving the effect of taking-out/storing and reading concurrently. In view of the problem that the false detection of the sensor leads to the damage of the wafer pod during movement of the equipment, the present disclosure avoids the problem of false detection through the plurality of detection sensors 80 at different positions, combined with the corresponding access method for the robotic arm. The running accuracy of the access plate 5 can be improved by providing different detection sensors 80, the use safety of the stacker can be ensured, misjudgment can be avoided, and the influence of manual assembly error can be reduced while improving the detection accuracy, such that the debugging difficulty of the machine can be indirectly reduced.

In the implementation, the detection accuracy can be improved by a plurality of detection sensors 80 at different positions. Specifically, the detection sensors 80 include at least a first sensor 801 provided at a side end of the access plate 5 and a second sensor 802 provided at a front end of the access plate 5. The first sensor 801 is configured to independently detect whether there is a corresponding wafer pod 40 in the storage position 30 of the warehouse when the access plate 5 needs to take out the wafer pod 40 from the storage position 30 and the access plate 5 is located at the designated position for waiting for article taking-out. The second sensor 802 is configured to independently detect whether there is no wafer pod 40 in the storage position 30 of the warehouse when the access plate 5 needs to store the wafer pod 40 into the storage position 30 and the access plate 5 is located at a designated position for waiting for article-storing.

In some embodiments, as shown in FIG. 23, the detection sensors 80 further include a third sensor 803 disposed above a rear end of the access plate 5, and the third sensor 803 is obliquely downward and faces the plate surface of the access plate 5. The third sensor 803 is configured to detect whether there is no wafer pod 40 on the plate surface of the access plate 5 in response to performing operation of taking out the wafer pod 40 from the storage position 30 of the warehouse by the access plate 5, and to detect whether there is the wafer pod 40 on the plate surface of the access plate 5 in response to performing operation of storing the wafer pod 40 into the storage position 30 by the access plate 5. With aid of the third sensor 803 disposed separately, it is possible to detect the presence or absence of the wafer pod 40 on the plate surface of the access plate when the wafer pod needs to be stored in the storage position 30 or needs to be taken out from the storage position 30.

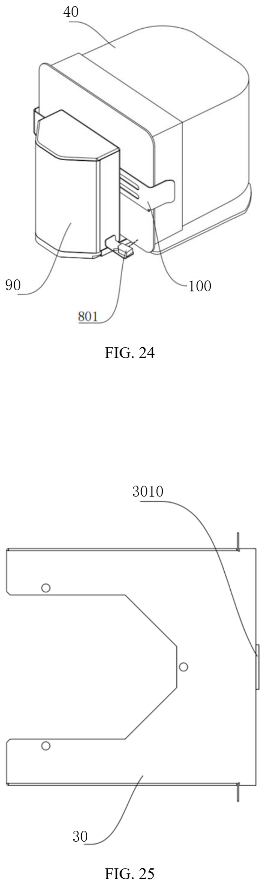

In some embodiments, the first sensor 801 and the second sensor 802 are reflective photoelectric sensors. As shown in FIG. 25, a reflective plate 3010 for sensing with the first sensor 801 and the second sensor 802 is provided on the storage position 30 of the warehouse. The reflective plate 3010 is configured to sense detection light of each of the two sensors. In response to performing operation of taking out the wafer pod 40 on the storage position 30 of the warehouse, the access plate 5 moves to the designated position for waiting for article taking-out, and the light emitted by the first sensor 801 is irradiated in the direction toward the reflective plate 3010. If the light returns, it indicates that there is no the wafer pod 40 in the current storage position 30 of the warehouse, and the system gives an alarm. In response to performing operation of storing the wafer pod 40 into the storage position 30, the access plate 5 moves to a designated position for waiting for article-storing, and the light emitted by the second sensor 802 is irradiated in the direction toward the reflective plate 3010. If the light returns, it indicates that there is no wafer pod 40 in the current storage position 30, such that the access plate 5 can continue to perform storing of the wafer pod 40. By the first sensor 801 and the second sensor 802 separately mounted, whether there is the wafer pod 40 on the storage position 30 of the warehouse is detected by the first sensor 801 when the access plate 5 is located at the designated position for waiting for article taking-out, or whether there is the wafer pod 40 on the storage position 30 of the warehouse is detected by the second sensor 802 when the access plate 5 is located at the designated position for waiting for article-storing, thereby improving the accuracy and pertinence of the detection, reducing the risk of false detection by the sensor, and reducing the influence of the assembly error of the reflective plate 3010, the debugging error generated during demonstrating, and the error of the stopping position of the robotic arm.

In some embodiments, as shown in FIG. 23, the plurality of detection sensors 80 further include a fourth sensor 804 and a fifth sensor 805 that are disposed on another side end of the access plate 5, where the fourth sensor 804 is disposed above the fifth sensor 805. When the stacker executes the task of storing and taking out of the wafer pod 40 with respect to the storage position 30, storing and taking out of the wafer pod 40 are achieved at two positions. For example, when the access plate needs to take out the wafer pod 40 from the storage position 30, the wafer pod 40 needs to be lifted from below a plate surface of the storage position 30 to realize the taking out of the wafer pod 40. When the access plate needs to store the wafer pod 40 into the storage position 30, the wafer pod 40 needs to be lowered down from above the plate surface of the storage position 30 until the wafer pod 40 falls on the storage position 30 of the warehouse to realize the storage of the wafer pod 40. Therefore, the access plate 5 of the robotic arm 1 has the two positions with respect to the storage position 30: a designated position for waiting for article taking-out and a designated position for waiting for article-storing (both positions being positioned in front of the storage position 30). By providing the fourth sensor 804 and the fifth sensor 805, the designated position for waiting for article taking-out and a designated position for waiting for article-storing of the current access plate 5 are detected respectively, such that the detection accuracy can be improved. The fourth sensor 804 is configured to detect whether the current access plate 5 is already located at the designated position for waiting for article taking-out relative to the storage position 30 when the access plate 5 performs taking out of the wafer pod 40 from the storage position 30. The fifth sensor 805 is configured to detect whether the current access plate 5 is already located at the designated position for waiting for article-storing relative to the storage position 30 when the access plate 5 performs storing of the wafer pod 40 into the storage position 30. A height difference between the fourth sensor 804 and the fifth sensor 805 in the vertical direction is equal to a height difference between the designated position for waiting for article taking-out and the designated position for waiting for article-storing, and a height difference between the first sensor and the second sensor in the vertical direction is equal to the height difference between the designated position for waiting for article taking-out and the designated position for waiting for article-storing.

In one example, the plurality of detection sensors 80 further include at least one sixth sensor 806 disposed on the plate surface of the access plate 5, and the sixth sensor 806 is configured to detect a position state of the wafer pod 40 on the current access plate 5. Specifically, the sixth sensor 806 detects whether the wafer pod 40 on the current access plate is put in place after the access plate 5 takes out the wafer pod 40 from the storage position 30. In addition, the third sensor 803 and the sixth sensor 806 can synchronously detect whether there is the wafer pod 40 on the access plate 5 in response to performing operation of storing the wafer pod 40 into the storage position 30 by the access plate 5, and the sixth sensor 806 can detect whether there is no wafer pod 40 on the access plate 5 after the wafer pod 40 is stored in the storage position 30.

In some embodiments, the sixth sensor 806 is a micro switch sensor, and the at least one sixth sensor is embodied as two sixth sensors 806.

In some embodiments, a positioning device 5010 for positioning the wafer pod 40 is provided on the plate surface of the access plate 5, and the positioning device 5010 may be a protrusion structure or a groove structure.

In one example, as shown in FIG. 23, the positioning device 5010 is a positioning protrusion fitted to the wafer pod 40, an upper end of the positioning protrusion has a spherical shape, and a positioning hole is defined correspondingly at the bottom of the wafer pod 40.

In some embodiments, as shown in FIG. 23, the access plate 5 is provided with a control box 90, and a protective plate 100 for positioning the wafer pod 40 is mounted on the control box 90. The protective plate 100 is configured to limit the degree of freedom of the wafer pod 40 and avoid movement of the wafer pod 40 in the horizontal direction.

In some embodiments, the fourth sensor 804 and the fifth sensor 805 are reflective laser sensors.

In some embodiments, the third sensor 803 is mounted on the control box 90 and the light emitted by the third sensor 803 is irradiated in the direction toward a central position of the plate surface of the access plate 5. The third sensor 803 is a reflective photoelectric sensor, and an inclined reflective sheet 503 corresponding to the third sensor 803 is provided on the plate surface of the access plate 5. The detection light emitted by the third sensor 803 is directed toward the inclined reflective sheet 503, and if a light returns, it indicates that there is the wafer pod 40 on the current access plate 5.

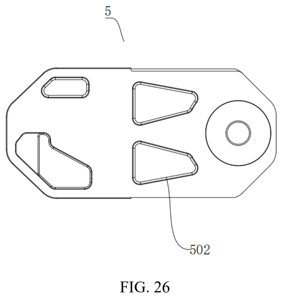

In some embodiments, as shown in FIG. 26, the access plate 5 defines at least one weight-reducing cavity 502 (cavity for reducing weight of the access plate 5). The at least one weight-reducing cavity 502 is arranged at a bottom space position of the access plate 5. The weight of the access plate 5 is greatly reduced on the basis of stress analysis. Through the at least one weight-reducing cavity 502, the weight of the access plate 5 can be reduced by about 10%, such that the influence of the weight of the robotic arm on the running speed of the stacker can be reduced, and the running performance of the equipment can be greatly improved.

As shown in FIGS. 14 and 15, embodiments of the present disclosure further provide an access method, which is implemented based on the robotic arm 1 of the semiconductor stacker according to any of the embodiments of the present disclosure. The access method includes a taking-out process of the wafer pod 40 and a storage process of the wafer pod 40, and the detection accuracy and detection speed are improved by providing a plurality of detection sensors 80 for detection at different positions of the access plate 5.

In the taking-out process of the wafer pod 40: the third sensor 803 detects whether there is no wafer pod 40 on the access plate 5, the fourth sensor 804 detects whether the current access plate 5 is already located at the designated position for waiting for article taking-out relative to the storage position 30, and the first sensor 801 separately disposed detects whether there is the wafer pod 40 on the storage position 30.

In the storage process of the wafer pod 40: the third sensor 803 detects whether there is the wafer pod 40 on the access plate 5, the fifth sensor 805 detects whether the current access plate 5 is already located at the designated position for waiting for article -storing relative to the storage position 30, and the second sensor 802 provided separately detects whether there is no wafer pod 40 in the storage position 30.

The RFID reader 70 provided at the front end of the access plate 5 directly reads the corresponding information of the wafer pod 40 when the access plate 5 takes out the wafer pod 40 from the storage position 30 and when the access plate 5 stores the wafer pod 40 in the storage position 30.

It shall be pointed out that when the access plate 5 takes out the wafer pod 40 from the storage position 30, it is necessary to ensure that the current access plate 5 does not have the wafer pod 40, and there is the wafer pod 40 stored in the storage position 30. Similarly, when the access plate 5 stores the wafer pod 40 into the storage position 30, it is necessary to ensure that the current access plate 5 has the wafer pod 40, and there is no wafer pod 40 in the storage position 30.

In some embodiments, as shown in FIG. 14, the taking-out process of the wafer pod 40 specifically includes the following operations.

At S001, the third sensor detects that there is no wafer pod on the access plate.

The third sensor 803 detects a state of the wafer pod 40 on the access plate 5. The third sensor 803 on the access plate 5 detects whether there is no wafer pod 40 on the plate surface of the access plate 5; and if there is the wafer pod 40 on the plate surface of the access plate 5, an alarm is issued.

At S002, the access plate 5 is moved to the designated position for waiting for article taking-out.

The access plate 5 is moved to a designated position for waiting for article taking-out in front of the storage position 30.

At S003, the fourth sensor detects that the access plate is already located at the designated position for waiting for article taking-out. The first sensor detects that there is the wafer pod on the storage position.

The fourth sensor 804 detects a current position of the access plate 5, and the first sensor 801 detects a state of the wafer pod 40 on the storage position 30. The fourth sensor 804 detects that the access plate 5 is located at the designated position for waiting for article taking-out of the access plate 5 relative to the storage position 30 of the warehouse. If the access plate 5 is not located at the designated position, an alarm is issued. The first sensor 801 synchronously detects whether there is the wafer pod 40 on the storage position 30; and if there is no wafer pod 40 on the storage position 30, an alarm is issued.

At S004, the access plate enters the storage position and rises to lift the corresponding wafer pod.

The access plate 5 is moved by a predetermined distance relative to the storage position 30 and rises. The access plate 5 enters the storage position 30 and rises to lift the corresponding wafer pod 40.

At S005, the sixth sensor detects that the wafer pod is already placed on the access plate, and the RFID reader reads information of the wafer pod.

The sixth sensor 806 detects that the wafer pod 40 is already placed on the access plate 5, and the RFID reader 70 reads the information of the current wafer pod 40. The sixth sensor 806 on the access plate 5 detects whether the currently lifted wafer pod 40 is put in place, and if not, an alarm is issued. The information of the current wafer pod 40 is read by the RFID reader 70 directly disposed on the access plate 5.

At S006, the access plate is retracted and reset.

The access plate 5 is retracted and reset, and the operation of article taking-out is completed.

In some embodiments, the storage process of the wafer pod 40 specifically includes the following operations.

At S101, the third sensor detects that there is a wafer pod on the access plate, and the RFID reader reads information of the wafer pod.

The third sensor 803 detects the state of the wafer pod 40 on the access plate 5, and the RFID reader 70 reads the information of the current wafer pod 40. The third sensor 803 detects whether there is the wafer pod 40 on the plate surface of the access plate 5; and if there is no wafer pod 40 on the access plate 5, an alarm is issued. The RFID reader 70 on the access plate 5 reads the information of the current wafer pod 40.

At S102, the access plate 5 carrying the wafer pod 40 is moved to the designated position for waiting for article-storing.

The access plate 5 carrying the corresponding wafer pod 40 is moved to the designated position for waiting for article-storing in front of the storage position 30.

At S103, the fifth sensor detects that the access plate carrying the wafer pod is already located at the designated position for waiting for article-storing. The second sensor detects that there is no wafer pod on the storage position.

The fifth sensor 805 detects the current position of the access plate 5, and the second sensor 802 detects the state of the wafer pod 40 on the storage position 30. The fifth sensor 805 detects that the access plate 5 is located at the designated position for waiting for article-storing of the access plate 5 relative to the storage position 30, and if the access plate 5 is not located at the designated position, an alarm is issued. The second sensor 802 on the access plate 5 synchronously detects whether there is no wafer pod 40 on the storage position 30, and if there is the wafer pod 40 on the storage position 30, an alarm is given.

At S104, the access plate enters the storage position and moves downward to place the corresponding wafer pod.

The access plate 5 moves by a designated distance with respect to the storage position 30 and moves downward. The access plate 5 enters the storage position 30 and moves downward to place the corresponding wafer pod 40.

At S105, the sixth sensor detects that the wafer pod is removed from the access plate.

The sixth sensor 806 detects that the wafer pod 40 is removed from the access plate 5. The sixth sensor 806 on the access plate 5 detects whether the wafer pod 40 is already removed from the access plate 5, and if not, an alarm is issued.

At S106, the access plate is retracted and reset.

The access plate 5 is retracted and reset, and the operation of article storing is completed.

In some embodiments, the third sensor 803 is a reflective photoelectric sensor, and disposed at a position near the top of the rear end of the access plate 5. The light emitted by the third sensor 803 is irradiated obliquely downward and toward the plate surface of the access plate 5. The sixth sensor 806 is a micro switch sensor. The first sensor 801 is provided at the left side of the access plate 5, the third sensor 803 is provided at the front end of the access plate 5, and the first sensor 801 and the second sensor 802 are reflective photoelectric sensors.

In some embodiments, the fourth sensor 804 and the fifth sensor 805 are reflective laser sensors, and a height difference between the fourth sensor 804 and the fifth sensor 805 in the vertical direction is equal to a height difference between the designated position for waiting for article taking-out and the designated position for waiting for article-storing.

In the access method of the disclosure, the plurality of sensors at different positions cooperate with the RFID reader directly arranged on the access plate, so that the detection accuracy can be improved, the detection speed can be improved, and the efficiency of accessing of the wafer pod can be improved.

In some embodiments, when the stacker performs the task of accessing the wafer pod 40 relative to the storage position 30, since taking out of the wafer pod 40 and storing of the wafer pod 40 are achieved at two positions, the control system of the stacker needs to control the access plate 5 of the robotic arm 1 mounted on the lifting box 2 to reach two designated positions relative to the storage position 30: the designated position for waiting for article taking-out and the designated position for waiting for article-storing (both positions are in front of the storage position 30); and monitoring whether the current access plate 5 is located at the designated position for waiting for article taking-out and the designated position for waiting for article-storing by using the fourth sensor 804 and the fifth sensor 805. Specifically, in the taking-out process of the wafer pod 40, the access plate 5 is moved to the designated position for waiting for article taking-out in front of the storage position 30, and the fourth sensor 804 detects whether the current access plate 5 is already located at the designated position for waiting for article taking-out relative to the storage position 30. If the position is wrong, an alarm is issued and the position of the access plate 5 is adjusted to the correct position. If the position is correct, the access plate enters the storage position and rises to lift the corresponding wafer pod (the access plate 5 is moved by a specified distance relative to the storage position 30 and moves upward). In the storage process of the wafer pod 40, the access plate 5 is moved to the designated position for waiting for article-storing in front of the storage position 30, and the fifth sensor 805 detects whether the current access plate 5 is already located at the designated position for waiting for article-storing relative to the storage position 30. If the position is wrong, an alarm is issued and the position of the access plate 5 is adjusted to the correct position. If the position is correct, the access plate enters the storage position and moves downward to place the corresponding wafer pod (the access plate 5 moves by a designated distance relative to the storage position 30 and moves downward).

In view of the above, the stacker further includes the control system, and the control system controls the position of the access plate 5 in the Z-axis direction relative to the storage position 30 in real time (for example, the control system controls the access plate 5 to reach two designated positions relative to the storage position 30, adjust the position of the access plate 5 when the position of the access plate 5 is wrong, and move upward or downward when the position of the access plate 5 is correct, etc.). In the process of the position control, the control system of the stacker outputs a lifting instruction to control the movement of the pulley mechanism disposed on the upright column 14 and connected to the lifting box 2, and when the conveyor belt of the pulley mechanism moves by a designated distance along the Z-axis direction, the lifting box 2 where the access plate 5 is located moves up and down by a designated amount with the conveyor belt along the Z-axis direction, so as to realize the position control of the access plate 5.

Specifically, the stacker includes an upright column, a slider assembly, and a lifting box. The lifting box is slidably mounted on the upright column by the slider assembly. That is, the slider assembly is slidably mounted on the upright column, and connected to the lifting box. The stacker further includes a pulley mechanism, which acts as a main force to drive the slider assembly to move up and down on the upright column along the Z-axis direction, and further drives the lifting box to move along the Z-axis direction.

The pulley mechanism includes a drive wheel, a driven wheel, and a conveyor belt coupled with the drive wheel and the driven wheel, where one of the drive wheel and the driven wheel is disposed at a top end of the upright column 14 and the other of the drive wheel and the driven wheel is disposed at a bottom end of the upright column 14. The conveyor belt is connected to the slider assembly 201. In rotation of the drive wheel, the conveyor belt is driven to move around the drive wheel and the driven wheel, thereby driving the slider assembly 201 to move up and down in the Z-axis direction.

The control system of the stacker also needs to control the position of the access plate 5 in real time in the X-axis direction relative to the storage position 30. Specifically, the control system of the stacker controls the traveling module at the bottom of the upright column 14 to slide a specified distance on the slide rail disposed along the X-axis direction. In the present specification, the same and similar parts between the various embodiments may be referred to each other, and each embodiment focuses on the differences from the other embodiments. In particular, the description of the embodiments to be described later is relatively simple, and reference may be made to the partial description of the foregoing embodiments for related details.

It is to be noted that, in the embodiments provided in FIGS. 1 to 26, similar elements may employ different terminologies or different reference numerals (e.g., target storage position 17 of the warehouse and storage position 30 of the warehouse, driving arm assembly 4 and driving mechanism 60, first driving arm 6 and primary articulated arm, second driving arm 8 and secondary articulated arm, first sensor 1601 and first sensor 801, second sensor 1602 and second sensor 802, third sensor 1603 and third sensor 803, fourth sensor 1604 and fourth sensor 804, fifth sensor 1605 and fifth sensor 805, sixth sensor 1606 and sixth sensor 806), but the location and function are similar, respectively, and the details of the embodiments may be implemented in conjunction with each other without conflict.

The above is merely a specific embodiment of the present disclosure, but the scope of protection of the present disclosure is not limited thereto, and any changes or substitutions that can be easily conceived by those skilled in the art within the technical scope disclosed in the present disclosure should be covered within the scope of protection of the present disclosure. Therefore, the scope of protection of the present disclosure should be based on the scope of protection of the claims.

## Claims

1. A robotic arm of a semiconductor stacker, the robotic arm being configured to be mounted on a lifting box, wherein the robotic arm includes a robotic arm bottom plate, a driving arm assembly, and an access plate, and the driving arm assembly includes a first driving arm and a second driving arm, wherein the first driving arm is rotatably mounted on the robotic arm bottom plate through a first active driving mechanism, the second driving arm is provided with a driven linkage mechanism inside the second driving arm, and the first driving arm is provided with a second active driving mechanism inside the first driving arm; and
wherein the first active driving mechanism is configured as an independent power source to drive the first driving arm to rotate, and the second active driving mechanism is configured as an independent power source to drive the second driving arm to rotate relative to the first driving arm, wherein in rotation of the second driving arm, the second driving arm drives the driven linkage mechanism to synchronously drive the access plate to rotate, such that extension and retraction of the access plate in a linear direction is controlled by rotating the first driving arm, the second driving arm, and the access plate according to a set manner.

2. The robotic arm of claim 1, wherein the set manner satisfies Δα₂ = Δα₁ + Δα₃ during the extension or the retraction of the access plate in the linear direction, wherein Δα₁ represents an amount of change in a rotation angle of the first driving arm with respect to ray extending in a X-axis direction on the robotic arm bottom plate, Δα₂ represents an amount of change in a rotation angle of the second driving arm with respect to the first driving arm, and Δα₃ represents an amount of change in a rotation angle of the access plate with respect to the second driving arm.

3. The robotic arm of claim 2, wherein the first driving arm is provided with a rotating seat extending downward from a bottom of an arm body of the first driving arm and connected to the first active driving mechanism, and the first active driving mechanism is disposed outside the first driving arm, wherein the robotic arm bottom plate, the rotating seat, and the first active driving mechanism are disposed in the lifting box, and the arm body of the first driving arm, the second driving arm, and the access plate are provided outside the lifting box in a vertical direction.

4. The robotic arm of claim 3, wherein a first rotation point is formed between the first driving arm and the robotic arm bottom plate, a second rotation point is formed between the first driving arm and the second driving arm, and a third rotation point is formed between the second driving arm and the access plate, wherein a connecting line between the first rotation point and the third rotation point is collinear with a symmetrical center line of the access plate, and the symmetrical center line of the access plate is parallel to a linear movement direction of the access plate.

5. The robotic arm of claim 4, wherein the driven linkage mechanism includes a first fixed wheel fixed in the second driving arm and a third driven wheel rotatably mounted in the second driving arm, wherein the first fixed wheel and the third driven wheel are rotatably and synchronously connected with each other, the first fixed wheel is located at the second rotation point, the third driven wheel is located at the third rotation point, and the third driven wheel is configured to drive the access plate to rotate synchronously.

6. The robotic arm of claim 5, wherein the first active driving mechanism includes a first driving motor mounted on the robotic arm bottom plate, a first drive wheel mounted on the first driving motor, and a first driven wheel rotatably connected with the first drive wheel synchronously, wherein the first driven wheel is located at the first rotation point, the first driven wheel is configured to drive the first driving arm to rotate, and the first drive wheel and the first driven wheel are disposed at a bottom of the robotic arm bottom plate.

7. The robotic arm of claim 6, wherein the second active driving mechanism includes a second driving motor disposed in the rotating seat, a second drive wheel mounted on the second driving motor, and a second driven wheel rotatably connected with the second drive wheel synchronously, wherein the second driven wheel is located at the second rotation point, the second driven wheel is configured to drive the second driving arm to rotate, and the second driven wheel is connected with the first fixed wheel to synchronously drive the second driving arm to rotate.

8. The robotic arm of claim 7, wherein the first fixed wheel and the third driven wheel are synchronously rotatably connected by a third conveyor belt, the first drive wheel and the first driven wheel are rotatably connected synchronously by a first conveyor belt, and the second drive wheel and the second driven wheel are rotatably connected by a second conveyor belt synchronously.

9. The robotic arm of claim 3, wherein the robotic arm bottom plate is provided with a first limit sensor and a second limit sensor on the robotic arm bottom plate, the first limit sensor and the second limit sensor are configured for limiting a rotation angle of the first driving arm, and the rotating seat is provided with a sensor detection sheet.

10. The robotic arm of claim 4, wherein the first driving arm is provided with a positioning plane for quick core-alignment on an outer side of the first driving arm, the access plate defines a first core alignment hole for quick core-alignment, and the rotating seat defines a second core alignment hole corresponding to the first core alignment hole.

11. The robotic arm of claim 10, wherein the robotic arm further comprises a first bolt, a second bolt, a rest block, and a holed bracket;
wherein the first bolt is inserted into the first core alignment hole and the second core alignment hole that are coaxially defined to lock the access plate and the rotating seat; and
wherein the second bolt is inserted into a hole of the holed bracket after passing through the rest block, the rest block is fixedly mounted on the positioning plane, and the holed bracket is fixedly mounted on the robotic arm bottom plate to lock the first driving arm and the robotic arm bottom plate.

12. The robotic arm of claim 11, wherein the second core alignment hole is disposed coaxially with the first rotation point, and each of the first bolt and the second bolt is provided with a pull ring.

13. The robotic arm of claim 1, wherein the robotic arm is configured to store a wafer pod into a storage position of a warehouse or take out the wafer pod from the storage position;
wherein the access plate is configured to carry the wafer pod, and the access plate is provided with a radio frequency identification (RFID) reader for directly reading information of the wafer pod and a plurality of detection sensors;
wherein the RFID reader is configured to directly read the information of the wafer pod in response to taking out the wafer pod from the storage position of the warehouse and storing the wafer pod into the storage position by the access plate; and
wherein the plurality of detection sensors are configured to detect at least one of whether there is the wafer pod on the storage position, whether there is the wafer pod on the access plate, a position of the access plate relative to the storage position, and a position of the wafer pod on the access plate.

14. The robotic arm of claim 13, wherein the plurality of detection sensors include at least:
a first sensor mounted at a side end of the access plate and a second sensor disposed at a front end of the access plate, wherein
the first sensor is configured to independently detect whether there is a corresponding wafer pod in the storage position in response to performing an operation of taking out the wafer pod from the storage position by the access plate and the access plate being located at a designated position for waiting for article taking-out; and
the second sensor is configured to independently detect whether there is no wafer pod in the storage position in response to performing an operation of storing the wafer pod into the storage position by the access plate and the access plate being located at a designated position for waiting for article-storing.

15. The robotic arm of claim 13 or 14, wherein the plurality of detection sensors further comprise a third sensor disposed above a rear end of the access plate, wherein the third sensor is configured to:
detect whether there is no wafer pod on a plate surface of the access plate in response to performing an operation of taking out the wafer pod from the storage position by the access plate; and
detect whether there is a wafer pod on the plate surface of the access plate in response to performing an operation of storing the wafer pod into the storage position by the access plate.

16. The robotic arm of any of claims 13 to 15, wherein the plurality of detection sensors further comprise a fourth sensor and a fifth sensor that are disposed on another side end of the access plate, and the fourth sensor is disposed above the fifth sensor;
wherein the fourth sensor is configured to detect whether the access plate is currently already located at a designated position for waiting for article taking-out relative to the storage position, in response to performing an operation of taking out a wafer pod from the storage position by the access plate;
wherein the fifth sensor is configured to detect whether the access plate is currently already located at a designated position for waiting for article-storing relative to the storage position, in response to performing an operation of storing the wafer pod into the storage position by the access plate; and
wherein a height difference between the fourth sensor and the fifth sensor in a vertical direction is equal to a height difference between the designated position for waiting for article taking-out and the designated position for waiting for article-storing, and a height difference between the first sensor and the second sensor in the vertical direction is equal to the height difference between the designated position for waiting for article taking-out and the designated position for waiting for article-storing.

17. The robotic arm of any of claims 13 to 16, wherein the plurality of detection sensors further comprise at least one sixth sensor disposed on a plate surface of the access plate, and the at least one sixth sensor is configured to detect a position state of the wafer pod on the access plate.

18. The robotic arm of claim 17, wherein the access plate is provided with a positioning device for positioning the wafer pod on the plate surface of the access plate.

19. The robotic arm of any of claims 15 to 18, wherein the access plate is provided with a control box on the access plate, a protective plate for positioning the wafer pod is mounted on the control box, the third sensor is mounted on the control box, and the access plate is provided with an inclined reflective sheet, corresponding to the third sensor, on the plate surface of the access plate.

20. The robotic arm of claim 17, wherein the sixth sensor is a micro switch sensor, both the fourth sensor and the fifth sensor are reflective laser sensors, and the first sensor, the second sensor, and the third sensor are reflective photoelectric sensors.

21. The robotic arm of any of claims 13 to 20, wherein the access plate defines at least one weight-reducing cavity, and the at least one weight-reducing cavity is arranged at a bottom space position of the access plate.

22. A method for operating a robotic arm of a semiconductor stacker, implemented by the robotic arm of the semiconductor stacker according to any of claims 2 to 10 and 13 to 21, wherein:
during the extension and the retraction of the access plate in the linear direction, the first driving arm, the second driving arm, and the access plate cooperate with each other to:
enable the access plate to be gradually extended in the linear direction from the initial origin position according to a set manner Δα₂ = Δα₁ + Δα₃ until the access plate reaches a target storage position of the warehouse; and
to enable the access plate to be gradually retracted in the linear direction according to the set manner Δα₂ = Δα₁ + Δα₃ until the access plate returns to the initial origin position;
wherein α₁ represents an angle of the first driving arm with respect to ray extending in an X-axis direction on the robotic arm bottom plate, and Δα₁ represents an amount of change in a rotation angle at which the first driving arm rotates clockwise or counterclockwise with respect to the ray extending in the X-axis direction on the robotic arm bottom plate;
wherein α₂ represents an angle of the second driving arm with respect to the first driving arm, and Δα₂ represents an amount of change in a rotation angle at which the second driving arm rotates clockwise or counterclockwise with respect to the first driving arm; and
wherein α₃ represents an angle of the access plate with respect to the second driving arm, and Δα₃ represents an amount of change in a rotation angle at which the access plate rotates clockwise or counterclockwise with respect to the second driving arm.

23. A semiconductor stacker, comprising the robotic arm of the semiconductor stacker of any of claims 2 to 21, wherein the stacker further comprises an upright column and the lifting box, the lifting box is slidably mounted on the upright column in a Z-axis direction, the upright column is provided with a traveling module at a bottom of the upright column, and the traveling module is slidably mounted on a horizontally disposed slide rail in an X-axis direction, wherein
in response to the robotic arm being at an initial origin position to perform an article taking-out task: the traveling module drives the stacker to move by a specified distance along an X-axis direction, the lifting box moves up and down by a specified distance along a Z-axis direction, a driving arm assembly of the robotic arm rotates to cause the access plate of the robotic arm to extend along a Y-axis direction to reach a designated storage position to take out the wafer pod, and to cause the access plate of the robotic arm to retract in a reverse direction of the Y-axis direction to reach the initial origin position; and
in response to the robotic arm being at the initial origin position to perform an article storing task: the traveling module drives the stacker to move by a specified distance along the X-axis direction, the lifting box moves up and down by a specified distance along the Z-axis direction, the driving arm assembly of the robotic arm rotates to cause the access plate of the robotic arm to extend in a Y-axis direction to place the wafer pod in a designated storage position, and to cause the access plate of the robotic arm to retract in the reverse direction of the Y-axis direction to reach the initial origin position.

24. The semiconductor stacker of claim 23, wherein the stacker further comprises:
a slider assembly slidably mounted on the upright column and coupled to the lifting box;
a pulley mechanism comprising a drive wheel, a driven wheel, and a conveyor belt coupled with the drive wheel and the driven wheel, wherein one of the drive wheel and the driven wheel is disposed at a top end of the upright column and the other of the drive wheel and the driven wheel is disposed at a bottom end of the upright column, wherein the conveyor belt is connected to the slider assembly, wherein in rotation of the drive wheel, the conveyor belt is driven to move around the drive wheel and the driven wheel, and the slider assembly is further driven to move on the upright column along the Z-axis direction; and
a control system, configured to output a lifting operation instruction in response to a position of the access plate being adjusted relative to the storage position in the Z-axis direction, and to control the pulley mechanism to drive the lifting box to move by a specified distance in the Z-axis direction.

25. An access method, implemented based on the robotic arm of the semiconductor stacker of claim 13, wherein the access method includes a wafer pod taking-out process and a wafer pod storage process;
detecting, by the plurality of detection sensors disposed at different positions of the access plate, at least one of whether there is the wafer pod on the storage position, whether there is the wafer pod on the access plate, a position of the access plate relative to the storage position, andwhether there is the wafer pod on the storage position; and
directly reading, by a RFID reader provided at a front end of the access plate, corresponding information of the wafer pod, in response to taking out the wafer pod from the storage position and storing the wafer pod into the storage position by the access plate.

26. The access method of claim 25, wherein the plurality of detection sensors includes a first sensor mounted on a side end of the access plate, a second sensor disposed on a front end of the access plate, a third sensor disposed above a rear end of the access plate, a fourth sensor and a fifth sensor disposed on another side end of the access plate, and at least one sixth sensor disposed on a plate surface of the access plate, wherein a height difference between the first sensor and the second sensor in the vertical direction is equal to the height difference between a designated position for waiting for article taking-out and a designated position for waiting for article-storing, and a height difference between the fourth sensor and the fifth sensor in a vertical direction is equal to a height difference between the designated position for waiting for article taking-out and the designated position for waiting for article-storing, wherein
in the wafer pod taking-out process: the third sensor detects whether there is no wafer pod on the access plate, the fourth sensor detects whether the access plate is currently already located at the designated position for waiting for article taking-out relative to the storage position, and the first sensor separately disposed detects whether there is the wafer pod on the storage position; and
in the wafer pod storage process: the third sensor detects whether there is the wafer pod on the access plate, the fifth sensor detects whether the access plate is currently already located at the designated position for waiting for article-storing relative to the storage position, and the second sensor provided separately detects whether there is no wafer pod in the storage position.

27. The access method of claim 26, wherein the wafer pod taking-out process includes:
detecting, by the third sensor, that there is no wafer pod on the access plate;
detecting, by the fourth sensor, that the access plate is already located at the designated position for waiting for article taking-out;
detecting, by the first sensor, that there is the wafer pod on the storage position;
entering, by the access plate, the storage position and rising to lift the wafer pod;
detecting, by the sixth sensor, that the wafer pod is already placed on the access plate, and reading, by an RFID reader, information of the wafer pod; and
performing retraction and reset of the access plate.

28. The access method of claim 26, wherein the wafer pod storage process includes:
detecting, by the third sensor, that there is the wafer pod on the access plate, and reading, by the RFID reader, information of the wafer pod;
detecting, by the fifth sensor, that the access plate carrying the wafer pod is already located at the designated position for waiting for article-storing;
detecting, by the second sensor, that there is no wafer pod on the storage position;
entering, by the access plate, the storage position and moving downward to place the wafer pod;
detecting, by the sixth sensor, that the wafer pod is removed from the access plate; and
performing retraction and reset of the access plate.
